(19) Europäisches Patentamt
European Patent Office
Office européen des brevets

(11) EP 4 733 849 A1

(12) EUROPEAN PATENT APPLICATION

(43) Date of publication:
29.04.2026 Bulletin 2026/18

(51) International Patent Classification (IPC):
*G03G 15/00* (2006.01)   *G06F 1/3234* (2019.01)
*H04N 1/00* (2006.01)

(21) Application number: 25208199.7

(22) Date of filing: 13.10.2025

(52) Cooperative Patent Classification (CPC):
G03G 15/5004; G03G 15/80; G06F 1/3284;
H04N 1/00888; H04N 1/00899

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH LA MA MD TN

(30) Priority: 28.10.2024 JP 2024189199

(71) Applicant: Canon Kabushiki Kaisha
Tokyo, 146-8501 (JP)

(72) Inventor: KOBAYASHI, Yo
Tokyo, 146-8501 (JP)

(74) Representative: TBK
Bavariaring 4-6
80336 München (DE)

(54) **IMAGE FORMING APPARATUS**

(57) An image forming apparatus (10) comprising an internal load (100, 130, 140, 150) provided inside the image forming apparatus, a connection unit (109, 110) to which an external load is connectable, and a computation unit (101) configured to calculate a power consumption value of the internal load. The computation unit adds a power consumption value of the external load connected to the connection unit and the power consumption value of the internal load in accordance with a power supply state of the external load.

# F I G. 1

**Description**

TECHNICAL FIELD

The present disclosure relates to an image forming apparatus.

BACKGROUND

In recent years, green transformation (GX) has emerged as an issue for companies. As a result, there is an increasing need to visualize the power consumption of image forming apparatuses such as multifunction printers (MFPs). Japanese Patent Laid-Open No. 2016-064521 proposes calculating not only the energy consumption of a thermal head, but also the energy consumption of a universal serial bus (USB) device.

SUMMARY

There are cases where a USB device is connected to a USB port of an image forming apparatus but the USB device is not powered on. According to Japanese Patent Laid-Open No. 2016-064521, even in such a case, it is assumed that the USB device is consuming the maximum amount of power when the power consumption of the image forming apparatus is calculated. Therefore, the accuracy of calculation of the power consumption of the image forming apparatus is low.

The present disclosure in its first aspect provides an image forming apparatus as specified in claim 1. Optional features are specified in claim 2 to 22.

Features of the present disclosure will become apparent from the following description of embodiments with reference to the attached drawings.

BRIEF DESCRIPTION OF THE DRAWINGS

The accompanying drawings, which are incorporated in and constitute a part of the specification, illustrate embodiments of the present disclosure, and together with the description, serve to explain the principles of the embodiments.

FIG. 1 is a diagram illustrating an image forming apparatus.
FIG. 2 is a diagram illustrating a user interface.
FIG. 3 is a state transition diagram regarding power states.
FIG. 4 is a diagram for describing an energy consumption adding method and cumulating method.
FIG. 5 is a diagram for describing the energy consumption adding method.
FIG. 6 is a block diagram illustrating functions of a computation unit.
FIG. 7 is a diagram illustrating a first table.
FIG. 8 is a diagram illustrating a second table.
FIG. 9 is a diagram illustrating the energy consumption cumulating method.
FIG. 10 is a flowchart illustrating a control method.
FIG. 11 is a flowchart illustrating the control method.
FIGS. 12A and 12B are sequence diagrams illustrating processing for acquiring information from a server computer.

DESCRIPTION OF THE EMBODIMENTS

Hereinafter, embodiments will be described in detail with reference to the attached drawings. Note, the following embodiments are not intended to limit the scope of the claims. Multiple features are described in the embodiments, but it is not the case that all such features are required, and multiple such features may be combined as appropriate. Furthermore, in the attached drawings, the same reference numerals are given to the same or similar configurations, and redundant description thereof is omitted.

First Embodiment

1. Image forming apparatus

In a first embodiment, descriptions will be given for a power consumption calculation method that takes into account the energization state of an optional device connected to an image forming apparatus, and a configuration for realizing the power consumption calculation method.

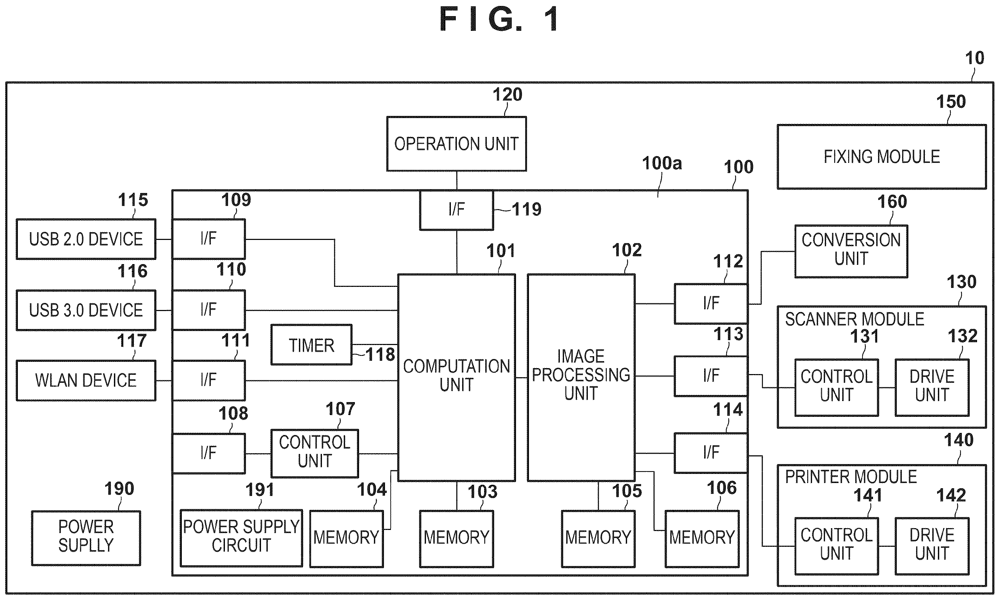

FIG. 1 is a diagram illustrating the configuration of an image forming apparatus 10. The image forming apparatus 10 mainly includes a controller module 100, an operation unit 120, a scanner module 130, a printer module 140, and a fixing module 150.

The controller module 100 has a board 100a, and components implemented on the board 100a may include a computation unit 101, an image processing unit 102, memories 103 to 106, a control unit 107, I/Fs 108 to 114, a timer 118, and a power supply circuit 191. I/F is an abbreviation for "interface", and may also be called a port, a connector, or a terminal according to the technical standard (e.g., the Universal Serial Bus standard). The power supply circuit 191 may include a USB controller. The USB controller may include a communication circuit for performing communication with a USB device, and a power supply circuit for providing power to the USB device.

The board 100a may be constituted by a single circuit board or a plurality of circuit boards. The computation unit 101 is a processor (e.g., a central processing unit (CPU)) that is responsible for controlling the power state of the image forming apparatus 10 and handling print jobs received from peripheral equipment (e.g., a personal computer (PC)). When the image forming apparatus 10 is started up, the computation unit 101 reads out a boot program stored in the memory 104, which is a non-volatile memory. The read program is deployed to the memory 103, which is a volatile memory. The boot program may be, for example, a basic input output system (BIOS), a boot loader, or an operating system (OS).

The non-volatile memory 104 is, for example, a read-only memory (ROM), an embedded multimedia card (eMMC), or the like. The non-volatile memory 104 may include a random access memory (RAM) that is continuously powered by a battery. The volatile memory 103 includes, for example, a RAM. The RAM may be, for example, a dynamic RAM (DRAM). The volatile memory 103 is used as a work memory by the computation unit 101.

The computation unit 101 is connected to the control unit 107. The control unit 107 is a communication circuit that performs communication with peripheral equipment, such as a PC, via the I/F 108, which is a wired LAN interface. LAN is an abbreviation for Local Area Network. An RJ-45 standard connector is generally used as the I/F 108 for a wired LAN. Also, Transmission Control Protocol/Internet Protocol (TCP/IP) or the like is used as the communication protocol. The computation unit 101 and the control unit 107 are connected via, for example, a Peripheral Component Interconnect express (PCIe) bus. The control unit 107 is connected to the I/F 108.

When the PC transmits a print job to the image forming apparatus 10 via a wired LAN, the control unit 107 receives the print job and transfers the print job to the computation unit 101. The computation unit 101 outputs, to the image processing unit 102, instructions for driving the scanner module 130 and the printer module 140 in accordance with the print job.

The image processing unit 102 is a second processor and may be integrated with the computation unit 101. The image processing unit 102 performs image processing (e.g., noise removal, color conversion) on scanned data of an original received from the scanner module 130, and generates image data. The image processing unit 102 stores the image data in the non-volatile memory 106. The image processing unit 102 converts the input image data and transmits the converted data to the printer module 140. Here, the format of the image data is converted into a format readable by the printer module 140. In this way, a duplicate of the original is realized. The image data acquired by the scanner module 130 is bitmap data in a red-green-blue (RGB) format. Meanwhile, the printer module 140 forms images on a recording medium using yellow, magenta, cyan, and black (YMCK) toner or ink. Therefore, the image processing unit 102 needs to execute color conversion. The image processing unit 102 and the scanner module 130 are connected via the I/F 113. The image processing unit 102 and the printer module 140 are connected via the I/F 114.

The image processing unit 102 has the volatile memory 105 that functions as a work memory. The non-volatile memory 106 may include, for example, a ROM and a solid-state drive (SSD).

The image forming apparatus 10 can be connected to a printer server (not shown). This enables jobs created for respective users to be executed in cooperation with a workflow system. The printer server is connected to the controller module 100 via a conversion unit 160. The conversion unit 160 is a communication conversion circuit for enabling the image forming apparatus 10 to perform communication with a server computer. The conversion unit 160 is connected to the image processing unit 102 via the I/F 112. The conversion unit 160 converts the format of image data received from the printer server into a format readable by the image processing unit 102. The printer server and the conversion unit 160 are both optional devices, or the conversion unit 160 is an optional device. While the image forming apparatus 10 is in operation, connection of the printer server and the conversion unit 160 to the controller module 100 is prohibited, and removal of the printer server and the conversion unit 160 from the controller module 100 is prohibited.

The computation unit 101 also has the I/Fs 109 to 111 to which optional devices can be connected. The I/F 109 is a USB 2.0 port to which a USB 2.0 device 115 is connected. The USB 2.0 device 115 operates in compliance with the technical standard commonly known as USB 2.0. The USB 2.0 device 115 is, for example, a memory device or a card authentication device. "USB 2.0" is the abbreviation for version 2.0 of the USB standard. In the first embodiment, it is assumed that the USB 2.0 device 115 is a memory device. The I/F 110 is a USB 3.0 port to which a USB 3.0 device 116 is connected. The USB 3.0 device 116 operates in compliance with the technical standard commonly known as USB 3.0. The USB 3.0 device 116 is, for example, a memory device, a protocol conversion device for conversion to the Ethernet standard, or the like. "USB 3.0" is the abbreviation for version 3.0 of the USB standard. In the first embodiment, the USB 3.0 device 116 is assumed to be a memory device. The memory device can be connected and disconnected even while the image forming apparatus 10 is in operation.

A WLAN device 117 is connected to the computation unit 101 via an I/F 111. "WLAN" is an abbreviation for Wireless LAN. The technical standard applied between the WLAN device 117 and the computation unit 101 may be, for example, USB or Secure Digital Input Output (SDIO). While the image forming apparatus 10 is in operation, connection of the WLAN device 117 to the image forming apparatus 10 is prohibited, and removal of the WLAN device 117 from the image forming apparatus 10 is prohibited.

The controller module 100 has the timer 118 that is connected to the computation unit 101. The timer 118 may be a so-called real-time clock (RTC). The timer 118 can maintain date and time information. The timer 118 receives a constant supply of power from a battery (not shown) (e.g., a lithium ion battery). The timer 118 therefore can hold information even while the image forming apparatus 10 is not powered. The RTC may be implemented inside the computation unit 101.

In the first embodiment, it is assumed that the computation unit 101 cumulates power consumption (unit: watts) to obtain energy consumption (unit: watt-hours or watt-seconds) and presents the energy consumption to a user. Therefore, the computation unit 101 needs time information for identifying the period during which the power consumption was measured. For example, the computation unit 101 acquires time information from the timer 118 and stores the acquired time information in the volatile memory 103. The computation unit 101 uses the time information stored in the memory 103 to calculate the time between two given times. Generally, even when the image forming apparatus 10 transitions to a power saving state, the volatile memory 103 continues to receive power, and therefore the time information is not erased.

The operation unit 120 is connected to the computation unit 101 via the I/F 119. The operation unit 120 has a display (e.g., a liquid crystal display device) that displays the status of the image forming apparatus 10 to the user, and an input device (e.g., a panel-type touch sensor, hardware keys) that accepts various instructions from the user. The computation unit 101 displays the value of power consumed by the image forming apparatus 10 on the display of the operation unit 120. A video signal provided by the computation unit 101 to the operation unit 120 is transmitted via, for example, a DisplayPort (DP) or a High Definition Multimedia Interface (HDMI (registered trademark)).

The scanner module 130 includes a control unit 131 and a drive unit 132. The control unit 131 controls the drive unit 132 to read an original placed on an original platen (not shown) and generate image data corresponding to the original. The drive unit 132 drives, for example, an automatic document feeder (ADF) to feed the original to the scanner module 130. The drive unit 132 drives a light emitting diode (LED) to illuminate the original, and drives an image sensor that converts the light from the original into color information.

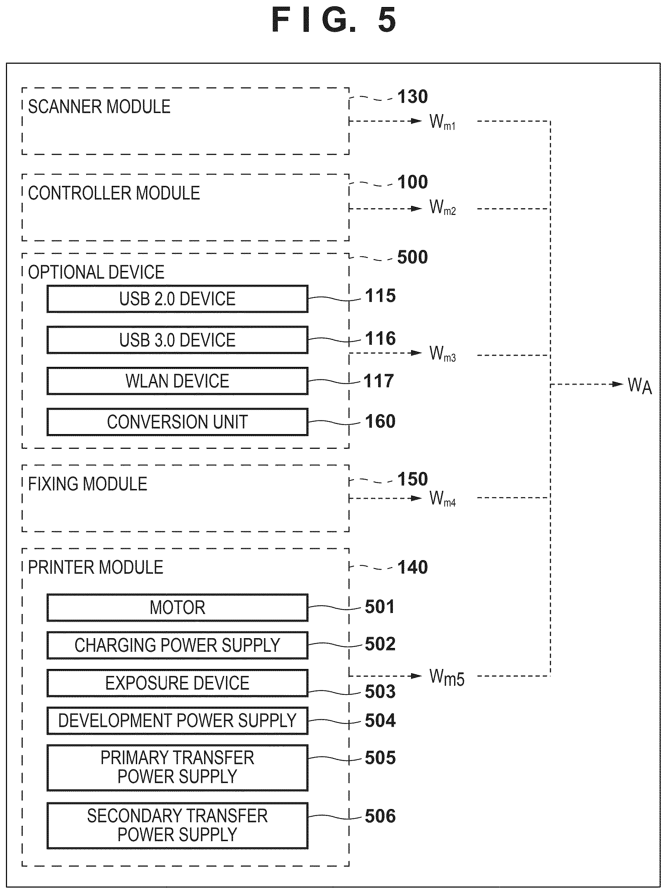

The printer module 140 includes a control unit 141 and a drive unit 142. The control unit 141 controls the drive unit 142 to form images and characters on a recording medium. As shown in FIG. 5, the drive unit 142 drives, for example, a motor 501 that rotates a photosensitive drum, a charging power supply 502 that charges the photosensitive drum, and an exposure device 503 that irradiates the photosensitive drum with light to form an electrostatic latent image. The drive unit 142 drives a development power supply 504 that develops the electrostatic latent image using toner to form a toner image, a primary transfer power supply 505 that transfers the toner image from the photosensitive drum to an intermediate transfer body, and a secondary transfer power supply 506 that transfers the toner image from the intermediate transfer body to a recording medium.

The fixing module 150 has a fixing roller (or a cylindrical heating film) and a pressure roller, and applies heat and pressure to the recording medium onto which the toner image has been transferred. As a result, the toner image is fixed onto the recording medium.

A power supply 190 is a power supply device that converts alternating current supplied from an AC power supply into direct current. The power supply circuit 191 supplies the DC voltage received from the power supply 190 to various external loads (optional devices) via the I/Fs 109 to 112. The power supply circuit 191 is controlled by the computation unit 101, and switches between supplying and cutting off (stopping supply) power to various optional devices. The power supply circuit 191 also supplies the DC voltage to internal loads (e.g., the controller module 100, the scanner module 130, the printer module 140, and the fixing module 150).

2. User Interface (UI)

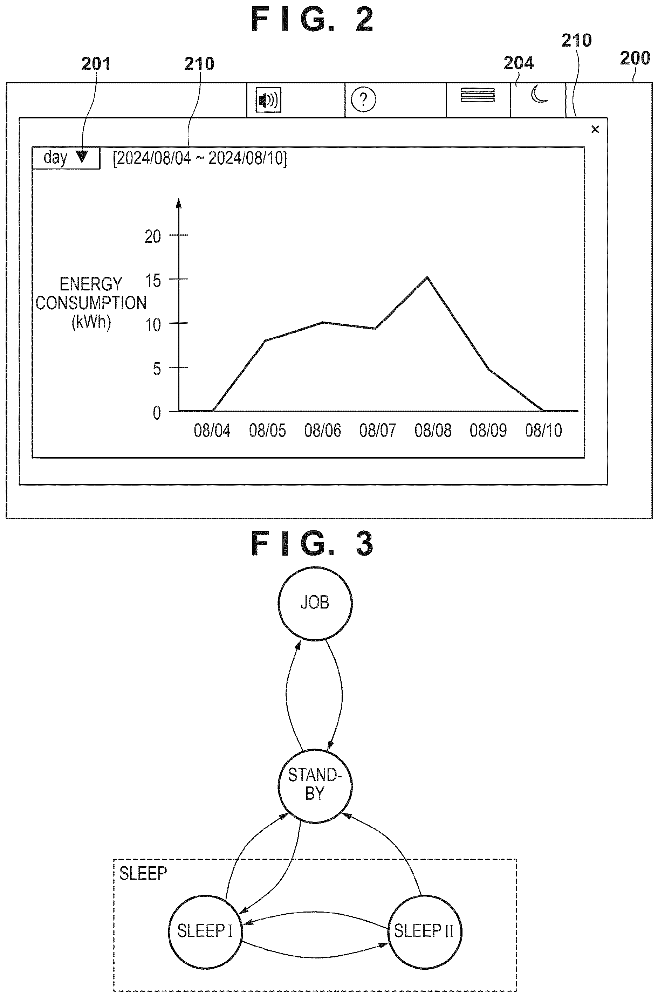

FIG. 2 shows an example of a UI 200 displayed on the operation unit 120. The UI 200 has an icon 204 indicating the power state or the operation state of the image forming apparatus 10 and a graph display area 210 displaying the energy consumption of the image forming apparatus 10. The computation unit 101 cumulates the energy consumption of the image forming apparatus 10 over a predetermined statistical period as a unit of time. A tab 201 is a designation object for designating the statistical period. Specifically, the tab 201 can be used to switch the position of the predetermined statistical period on the time axis or the length of the predetermined statistical period. The designation object may be realized by a pull-down list displaying a list of units of time. In FIG. 2, "day" is specified as the statistical period in the tab 201. Therefore, the computation unit 101 calculates the energy consumption by cumulating the power consumption value for each day, creates a graph showing change in the energy consumption over one week, and displays the graph in the graph display area 210. According to the user selection result in the tab 201, the computation unit 101 may switch the energy consumption to a cumulative value for one day, one week, or one month, and display the result on the operation unit 120. In other words, the computation unit 101 switches the energy consumption statistical period based on the selection result in the tab 201.

When the image forming apparatus 10 is installed in a customer's room, the computation unit 101 may create power consumption value log data and store the log data in the non-volatile memory 104. As a result, the computation unit 101 may refer to the log data, cumulate the power consumption values (W) for a specified statistical period (cumulation period), and display the energy consumption (Wh) on the operation unit 120. For example, the date on which the image forming apparatus 10 is installed in the customer's room may be specified as the start date of the statistical period, and "today" may be specified as the end date of the statistical period. In this manner, the statistical period may be selected by the user, or may be determined in advance.

The operation unit 120 may display the energy consumption for each of the function modules that configure the image forming apparatus 10. For example, the energy consumption of the controller module 100 and the energy consumption of the fixing module 150 may be displayed in separate columns or as separate graphs.

3. Power consumption cumulating method (energy consumption calculation method)

FIG. 3 is a diagram illustrating state transitions that occur between power states. Here, the image forming apparatus 10 has a plurality of power states. The job state (JOB) is a state in which printing or scanning is being executed. The standby state (STANDBY) is a state in which the image forming apparatus 10 is waiting for a job. The sleep state (SLEEP) is a state in which the image forming apparatus 10 is operating with reduced power consumption. Note that the sleep state (SLEEP) may include a plurality of sleep states (e.g., SLEEP I, SLEEP II) in each of which the power consumption is different. SLEEP I and SLEEP II are sub states of the sleep state. Note that the power consumption in SLEEP II is lower than the power consumption in SLEEP I.

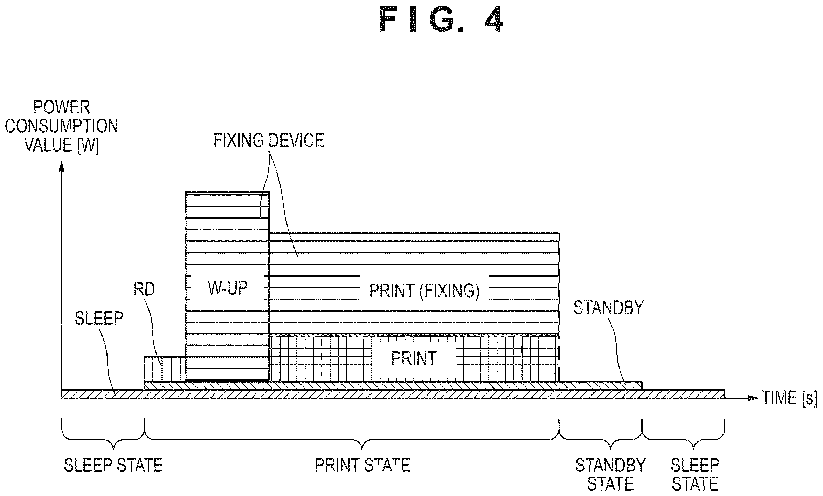

FIG. 4 shows power consumption values Pm (W) and energy consumption Wm (Wh) for the various power states. The horizontal axis indicates time. The vertical axis indicates the power consumption value Pm. The area of a hatched rectangle indicates the energy consumption Wm (Wh).

The power consumption value Pm and the energy consumption Wm are very small in the sleep state. However, the loads (communication circuit, etc.) that operate in the sleep state also operate in the job state and standby state. When a copy job is input to the image forming apparatus 10, the image forming apparatus 10 transitions from the sleep state to the job state. The scanner module 130 executes original reading. The power consumption value Pm and the energy consumption Wm during scanning of an original are denoted as RD. The loads that operate in the standby state (the operation unit 120, etc.) also operate in the job state. The power consumption value Pm and the energy consumption Wm of such loads are indicated as STANDBY. When the reading of the original is completed, the fixing module 150 is woken up. The power consumption value Pm and the energy consumption Wm at this time are indicated as W-UP. When wake-up of the fixing module 150 is completed, image formation is executed on a recording medium. PRINT indicates the power consumption of the printer module 140 and the like. PRINT (fixing) indicates the power consumption value Pm and the energy consumption Wm of the fixing module 150. When the copy job is completed, the image forming apparatus 10 transitions from the job state to the standby state. Furthermore, if the length (time) of the period during which a successive job has not been input in the standby state exceeds a threshold, the image forming apparatus 10 transitions from the standby state to the sleep state.

For each of the function modules, the computation unit 101 integrates (cumulates) the power consumption values Pm of the function module along the time axis to obtain the energy consumption Wm of the function module, and adds up the results for the function modules to obtain a total energy consumption WA. In other words, the total value of the areas of the plurality of rectangles shown in FIG. 4 indicates the total energy consumption WA (Wh). Here, the unit of energy consumption is assumed to be watt-seconds (Ws).

The computation unit 101 controls the supply and stop of power to the function modules according to the operation state (power state) of the image forming apparatus 10. Therefore, the energy consumption changes over time. The computation unit 101 can calculate the overall energy consumption of the image forming apparatus 10 by integrating (cumulating) the energy consumption of each of the function modules along the time axis.

FIG. 5 shows an example of the function modules. Wm1 indicates the energy consumption of the scanner module 130. Wm2 indicates the energy consumption of the controller module 100. Wm4 indicates the energy consumption of the fixing module 150. Wm5 indicates the energy consumption of the printer module 140. The printer module 140 includes the motor 501 for driving the photosensitive drum and conveying rollers, the charging power supply 502, the exposure device 503, the development power supply 504, the primary transfer power supply 505, and the secondary transfer power supply 506.

Wm3 is the energy consumption of optional devices 500 connected to the controller module 100. The optional devices 500 include, for example, the USB 2.0 device 115, the USB 3.0 device 116, the WLAN device 117, and the conversion unit 160.

The computation unit 101 calculates the energy consumption WA by adding up Wm1 to Wm5. The computation unit 101 may calculate the energy consumption WA (Ws) by cumulating the total values of the power consumption Pm1 to Pm5 along the time axis. In other words, the computation unit 101 can calculate the cumulative energy consumption of the image forming apparatus 10 by cumulating the energy consumption WA calculated based on the power state of the image forming apparatus 10 over a predetermined time (e.g., one day, one week, one month).

4. Functions of computation unit

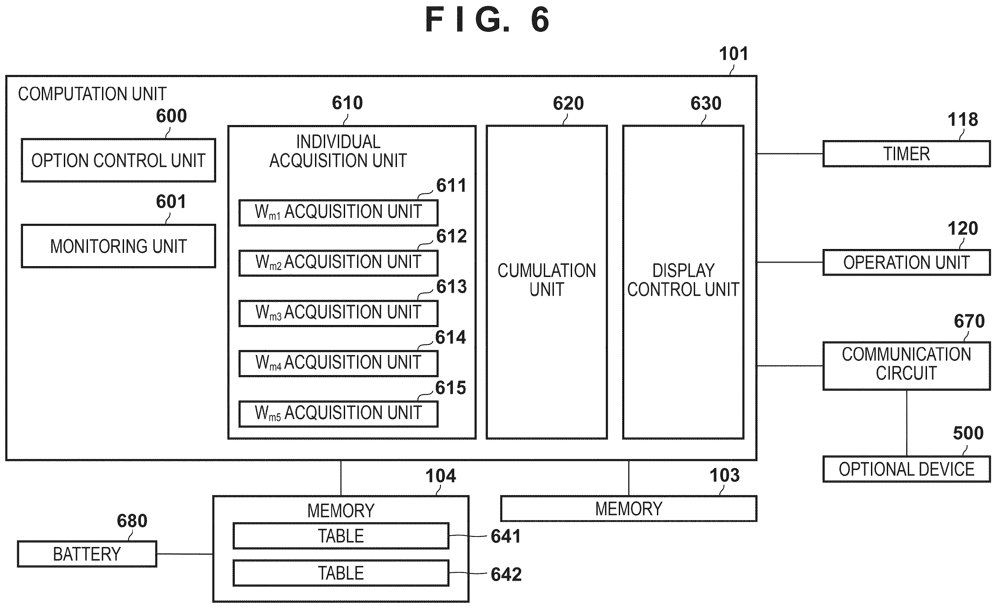

FIG. 6 shows functions of the computation unit 101. The computation unit 101 is connected to the volatile memory 103, the non-volatile memory 104, the timer 118, the operation unit 120, and a communication circuit 670. The computation unit 101 performs communication with the optional devices 500 via the communication circuit 670 and the I/Fs 109 to 112. A battery 680 supplies power to the memory 104.

An option control unit 600 mainly monitors the connection states of the optional devices 500 connected via the communication circuit 670. For example, the option control unit 600 executes initialization processing called enumeration to acquire device information of the devices connected to the I/Fs 109 to 112, for example, and create a device list. The option control unit 600 detects the connection and removal of USB devices to the I/Fs 109 and 110, and updates the device list. When the image forming apparatus 10 is started up, the computation unit 101 checks whether or not the WLAN device 117 is connected to the image forming apparatus 10 and whether or not the conversion unit 160 is connected to the image forming apparatus 10.

A monitoring unit 601 monitors the actual state of power supply to the optional devices 500. In other words, the monitoring unit 601 monitors the state of power supply to the external loads connected to the I/Fs 109 to 112. Even if an optional device 500 is connected to the image forming apparatus 10, there are cases where power is not supplied to that optional device 500. Therefore, in order to accurately obtain the energy consumption of the optional devices 500, it is necessary to monitor the energization state of the optional devices 500. The energization state of the optional devices 500 often changes in conjunction with the power state of the image forming apparatus 10, for example. Therefore, by monitoring the power state of the image forming apparatus 10, the monitoring unit 601 may acquire corresponding energization states of the optional devices 500.

Individual acquisition units 610 acquire the power consumption value Pm or the energy consumption Wm of corresponding function modules. A Wm1 acquisition unit 611 acquires the power consumption of the scanner module 130. For example, the Wm1 acquisition unit 611 acquires a fixed value indicating the power consumption of the scanner module 130, which is stored in the non-volatile memory 104. The Wm1 acquisition unit 611 may acquire, via the communication circuit 670, a power consumption value or an energy consumption calculated by the control unit 131 in the scanner module 130.

A Wm2 acquisition unit 612 acquires the power consumption value or the energy consumption of the controller module 100.

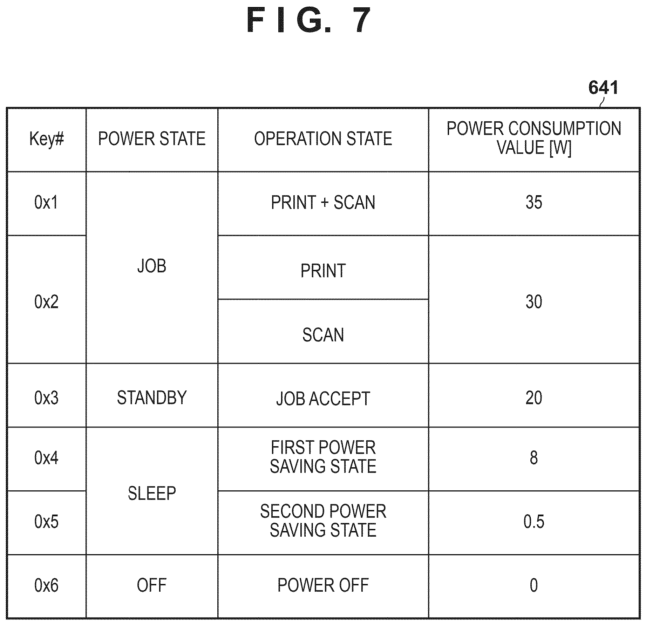

FIG. 7 shows a first table 641 that holds the power consumption value Pm of the controller module 100 for each of the power states. The first table 641 may be stored in the non-volatile memory 104. As shown in FIG. 7, the power consumption value Pm of the controller module 100 varies greatly according to the combination of the power state and the operation state of the image forming apparatus 10. For example, when the power state is JOB and the operation state is print + scan, the power consumption value is 35 (W). When the power state is JOB and the operation state is print or scan, the power consumption value is 30 (W). When the power state is STANDBY and the operation state is job accept, the power consumption value is 20 (W). When the power state is SLEEP and the operation state is a first power saving state, the power consumption value is 8 (W). When the power state is SLEEP and the operation state is a second power saving state, the power consumption value is 0.5 (W). When the power state is OFF and the operation state is power off, the power consumption value is 0 (W).

The first power saving state is a state in which the backlight of the operation unit 120 is turned off and power is not supplied to the conversion unit 160. In other words, in the first power saving state, various devices actively reduce power consumption by performing clock gating or power gating.

The second power saving state is a state in which power is supplied only to the volatile memory 103, the control unit 107, the timer 118, an interrupt control unit, the touch sensor provided in the operation unit 120, and the WLAN device 117. The interrupt control unit is provided in the computation unit 101. In the second power saving state, the volatile memory 103 is in a so-called self-refresh state. The control unit 107 uses a function called proxy response to filter out unnecessary packets received from the outside. The first power saving state and the second power saving state may be alternatively selected by the user. For example, if power saving is to be prioritized, the second power saving state is selected. If priority is to be given to shortening the time required for returning from the sleep state to the standby state, the first power saving state is selected.

The Wm2 acquisition unit 612 reads out, from the first table 641, the power consumption value that corresponds to the combination of the power state and the operation state.

A Wm3 acquisition unit 613 acquires the power consumption value Pm or the energy consumption Wm of the optional devices 500 connected to the controller module 100.

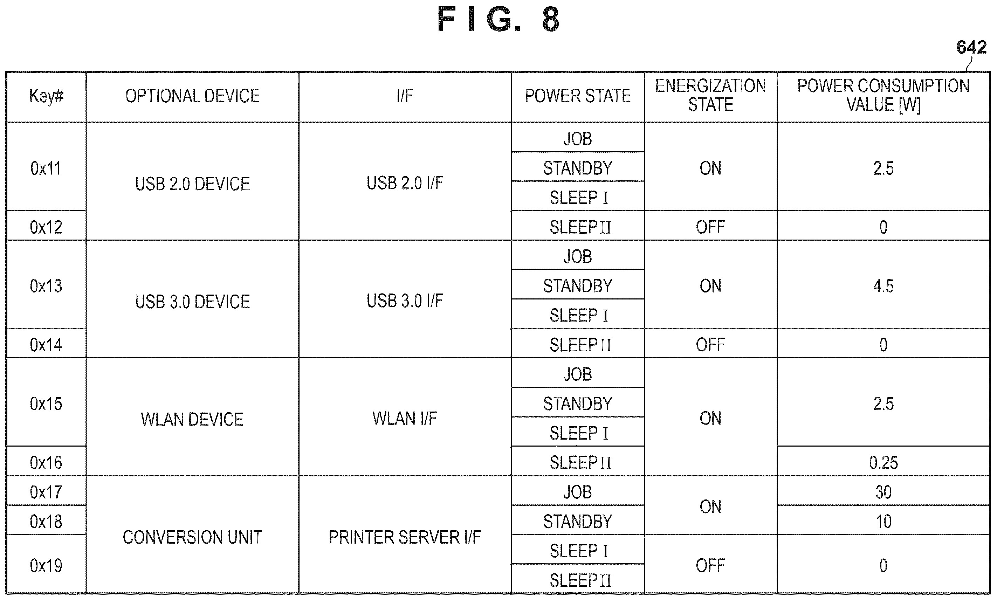

FIG. 8 shows a second table 642 that holds the power consumption values of the optional devices 500. The second table 642 is also stored in the non-volatile memory 104. As shown in FIG. 8, the power consumption values of the optional devices 500 also change according to the power state.

The power consumption value of the USB 2.0 device 115 changes according to the energization state. When the power state is JOB, STANDBY, or SLEEP I, the energization state is set to ON. As a result, the power consumption value of the USB 2.0 device 115 is 2.5 (W). When the power state is SLEEP II, the energization state is set to OFF. Therefore, the power consumption value of the USB 2.0 device 115 is 0 (W).

The power consumption value of the USB 3.0 device 116 also changes according to the energization state. When the power state is JOB, STANDBY, or SLEEP I, the energization state is set to ON. As a result, the power consumption value of the USB 3.0 device 116 is 4.5 (W). When the power state is SLEEP II, the energization state is set to OFF. Therefore, the power consumption value of the USB 3.0 device 116 is 0 (W).

The power consumption value of the WLAN device 117 changes according to the power state. The energization state of the WLAN device 117 is kept ON, regardless of the power state. When the power state is JOB, STANDBY, or SLEEP I, the power consumption value of the WLAN device 117 is 2.5 (W). When the power state is SLEEP II, the power consumption value of the WLAN device 117 is 0.25 (W).

The power consumption value of the conversion unit 160 changes according to the power state. When the power state is JOB, the energization state is set to ON. When the power state is JOB, the power consumption value of the conversion unit 160 is 30 (W). When the power state is STANDBY, the power consumption value of the conversion unit 160 is 10 (W). When the power state is SLEEP I or SLEEP II, the energization state is set to OFF. In this case, the power consumption value is 0 (W).

In this way, the power consumption values of the optional devices 500 change according to the power state. This is because the energization states of the optional devices 500 are switched according to the power state.

The Wm3 acquisition unit 613 refers to the second table 642 to acquire, for an optional device 500, the power consumption value that corresponds to the power state (energization state).

A Wm4 acquisition unit 614 acquires the power consumption value of the fixing module 150. A Wm5 acquisition unit acquires the power consumption value of the printer module 140. The Wm4 acquisition unit 614 reads out the power consumption value of the fixing module 150, which is a fixed value stored in the non-volatile memory 104. The Wm5 acquisition unit 615 reads out the power consumption value of the printer module 140, which is a fixed value stored in the non-volatile memory 104. The Wm4 acquisition unit 614 may acquire a power consumption value calculated by a control unit provided inside the fixing module 150 as the power consumption value of the fixing module 150. The Wm5 acquisition unit may acquire the power consumption value calculated by the control unit 141 provided inside the printer module 140.

For each function module, a cumulation unit 620 adds up the power consumption values or energy consumption acquired by the individual acquisition unit 610 to calculate the total energy consumption WA. Furthermore, the cumulation unit 620 calculates the cumulative energy consumption of the image forming apparatus 10 by cumulating the energy consumption WA along the time axis for a specific period of time. A display control unit 630 creates the UI 200 for displaying the cumulative energy consumption, and displays the UI 200 on the display of the operation unit 120.

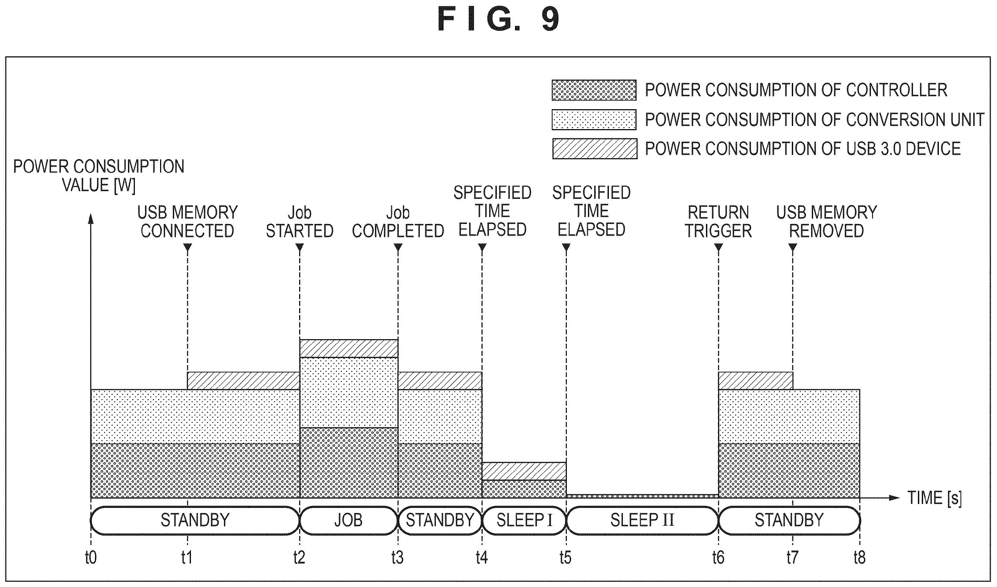

FIG. 9 shows a method for calculating the cumulative energy consumption by adding up the energy consumption Wm2 of the controller module 100 and the energy consumption Wm3 of the optional devices 500. The vertical axis indicates the power consumption value. The horizontal axis indicates time. The hatched rectangles indicate the energy consumption. The power state during the period from time t0 to time t2 is STANDBY. The power state during the period from time t2 to time t3 is JOB. The power state during the period from time t3 to time t4 is STANDBY. The power state during the period from time t4 to time t5 is SLEEP I. The power state during the period from time t5 to time t6 is SLEEP II. The power state during the period from time t6 to time t8 is STANDBY.

The computation unit 101 starts calculating the energy consumption from time t0. The start point may be, for example, the time when the user touches the tab 201 or the time when the image forming apparatus 10 is installed in the user's room. It is assumed here that the optional devices 500 connected to the image forming apparatus 10 are a printer server and the conversion unit 160. The controller module 100 supplies power to the conversion unit 160 according to the power state of the image forming apparatus 10.

At time t0, the power state of the image forming apparatus 10 is STANDBY. The Wm2 acquisition unit 612 refers to the first table 641 in the non-volatile memory 104. Since the power state is STANDBY, Key# 0x3 is referenced, and 20 (W) is acquired as the power consumption value of the controller module 100. The computation unit 101 may refer to the first table 641 deployed to the volatile memory 103. The option control unit 600 monitors the connection and removal of the conversion unit 160 to and from the I/F 112. For example, the option control unit 600 may detect the connection and removal of the conversion unit 160 through initialization processing that is based on the PCIe Bus standard used between the conversion unit 160 and the computation unit 101. The computation unit 101 may detect the connection and removal of the conversion unit 160 through a general purpose input/output (GPIO) provided in the conversion unit 160. When connection of the conversion unit 160 is detected, the Wm3 acquisition unit 613 refers to the second table 642 in the non-volatile memory 104. Since the power state is STANDBY, the Wm3 acquisition unit 613 refers to Key# 0x18 and acquires 10 (W) as the power consumption value. The cumulation unit 620 adds up the power consumption value 20 (W) of the controller module 100 and the power consumption value 10 (W) of the conversion unit 160 to obtain the cumulative value for the period from time t0 to time t1. A cumulative energy consumption Wt01 from time t0 to time t1 can be calculated using the following equation.

$$Wt01 = (20+10) \times (t1-t0) \qquad ...Eq.1$$

The computation unit 101 acquires the actual value of time t from the timer 118. The computation unit 101 may count the elapsed time by a program running on the computation unit 101.

At time t1, the user connects the USB 3.0 device 116 to the image forming apparatus 10. A USB memory that operates in compliance with the USB 3.0 standard is connected as the USB 3.0 device 116. The option control unit 600 detects that the USB 3.0 device 116 is connected to the image forming apparatus 10. For example, the connection may be detected by initialization processing that is based on the USB Bus standard executed between the computation unit 101 and the USB 3.0 device 116. The Wm3 acquisition unit 613 refers to the second table 642 in the non-volatile memory 104. Since the power state is STANDBY, the Wm3 acquisition unit 613 refers to Key# 0x13 and acquires 4.5 (W) as the power consumption value of the USB 3.0 device 116.

The cumulation unit 620 adds the power consumption value of 4.5 (W) to the power consumption value of 30 (W) acquired in the period from time t0 to time t1 to calculate a cumulative power consumption value Wt12 from time t1 to time t2.

$$Wt12 = (30+4.5) \times (t2-t1) \qquad ...Eq.2$$

At time t2, the user instructs the image forming apparatus 10 to execute a job. For example, execution of a print job is instructed via a wired LAN. As a result, the computation unit 101 switches the power state of the image forming apparatus 10 from STANDBY to JOB. When a change in the power state of the image forming apparatus 10 is detected, the Wm2 acquisition unit 612 refers to Key# 0x2 in the first table 641. As a result, 30 W is acquired as the power consumption value of the controller module 100. The Wm3 acquisition unit 613 refers to Key# 0x17 in the second table 642 and acquires 30 (W) as the power consumption value of the conversion unit 160. The Wm3 acquisition unit 613 refers to Key# 0x13 in the second table 642 and acquires 4.5 (W) as the power consumption value of the USB 3.0 device 116.

The cumulation unit 620 adds up these power consumption values to calculate a cumulative value for the period from time t2 to time t3. A cumulative power consumption value Wt23 for the period from time t2 to t3 can be calculated using the following equation.

$$Wt23 = (30+30+4.5) \times (t3-t2) \qquad ...Eq.3$$

When the job ends at time t3, the power state of the image forming apparatus 10 transitions from JOB to STANDBY. When the monitoring unit 601 detects a change in the power state of the image forming apparatus 10, the Wm2 acquisition unit 612 refers to Key# 0x3 in the first table 641 and acquires 20 (W) as the power consumption value of the controller module 100. The Wm3 acquisition unit 613 refers to Key# 0x18 in the second table 642 and acquires 10 (W) as the power consumption value of the conversion unit 160. The Wm3 acquisition unit 613 refers to Key# 0x13 in the second table 642 and acquires 4.5 (W) as the power consumption value of the USB 3.0 device 116. The cumulation unit 620 adds up these power consumption values to calculate a cumulative value for the period from time t3 to time t4. In other words, a cumulative power consumption value Wt34 for the period from time t3 to time t4 can be calculated using the following equation.

$$Wt34 = (20+10+4.5) \times (t4-t3) \qquad ...Eq.4$$

Time t4 is the timing when a specified time has elapsed since time t3 when the power state transitioned from JOB to STANDBY. The timer 118 notifies the computation unit 101 that the specified time has elapsed. In other words, the computation unit 101 uses the timer 118 to measure the specified time. At time t4, the computation unit 101 transitions the power state from STANDBY to SLEEP (first power saving state). At this time, the computation unit 101 controls the power supply circuit 191 to stop the supply of power to the conversion unit 160. This reduces power consumption. On the other hand, the power supply circuit 191 continues to supply power to the USB 3.0 device 116. In response to the change in the power state of the image forming apparatus 10, the Wm2 acquisition unit 612 refers to Key# 0x4 in the first table 641 and acquires 8 (W) as the power consumption value of the controller module 100. Furthermore, the Wm3 acquisition unit 613 refers to Key# 0x19 in the second table 642 and acquires 0 (W) as the power consumption value of the conversion unit 160. Furthermore, the Wm3 acquisition unit 613 refers to Key# 0x13 in the second table 642, and acquires 4.5 (W) as the power consumption value of the USB 3.0 device 116. The cumulation unit 620 adds up these power consumption values and continues cumulation until time t5. In other words, a cumulative power consumption value Wt45 from time t4 to t5 can be calculated using the following equation.

$$Wt45 = (8+0+4.5) \times (t5-t4) \qquad ...Eq.5$$

Time t5 is the timing when a specified time has further elapsed from time t4. When the timer 118 notifies the computation unit 101 that the specified time has elapsed, the computation unit 101 transitions the power state of the image forming apparatus 10 from the first power saving state to the second power saving state. The computation unit 101 controls the power supply circuit 191 to stop the supply of power to the USB 3.0 device 116. This further reduces power consumption. When the monitoring unit 601 detects a change in the power state of the image forming apparatus 10, the Wm2 acquisition unit 612 refers to Key# 0x5 in the first table 641 and acquires 0.5 (W) as the power consumption value of the controller module 100. The Wm3 acquisition unit 613 refers to Key# 0x19 in the second table 642 and acquires 0 (W) as the power consumption value of the conversion unit 160. The Wm3 acquisition unit 613 refers to Key# 0x14 in the second table 642 and acquires 0 (W) as the power consumption value of the USB 3.0 device 116. The cumulation unit 620 adds up these power consumption values to calculate a cumulative value for the period from time t5 to time t6. In other words, a cumulative power consumption value Wt56 for the period from time t5 to time t6 can be calculated using the following equation.

$$Wt56 = (0.5+0+0) \times (t6–t5) \qquad ...Eq.6$$

At time t6, the user inputs a return trigger for the image forming apparatus 10. One example of the return trigger is when the user touches the touch sensor of the operation unit 120. As a result, the computation unit 101 transitions the power state of the image forming apparatus 10 from SLEEP II to STANDBY. The computation unit 101 controls the power supply circuit 191 to resume the supply of power to the conversion unit 160 and the USB 3.0 device 116. When the monitoring unit 601 detects a change in the power state of the image forming apparatus 10, the Wm2 acquisition unit 612 refers to Key# 0x3 in the first table 641 and acquires 20 (W) as the power consumption value of the controller module 100. The Wm3 acquisition unit 613 refers to Key# 0x18 in the second table 642 and acquires 10 (W) as the power consumption value of the conversion unit 160. The Wm3 acquisition unit 613 refers to Key# 0x13 in the second table 642 and acquires 4.5 (W) as the power consumption value of the USB 3.0 device 116. The cumulation unit 620 adds up these power consumption values to calculate a cumulative value for the period from time t6 to time t7. In other words, a cumulative power consumption value Wt67 for the period from time t6 to t7 can be calculated using the following equation.

$$Wt67 = (20+10+4.5) \times (t7–t6) \qquad ...Eq.7$$

At time t7, the user removes the USB memory, which is the USB 3.0 device 116, from the I/F 110. The option control unit 600 detects that the USB 3.0 device 116 has been removed from the I/F 110. For example, a user instruction for removal of the USB memory is input from the operation unit 120. When it is detected that the communication signal from the USB 3.0 device 116 has disappeared, the computation unit 101 determines that the USB 3.0 device 116 was removed. In response to the USB 3.0 device 116 being removed, the Wm3 acquisition unit 613 notifies the cumulation unit 620 of only the power consumption value of the conversion unit 160. In other words, a cumulative power consumption value Wt78 from time t7 to time t8 can be calculated using the following equation.

$$Wt78 = (20+10) \times (t8–t7) \qquad ...Eq.8$$

4. Flowchart

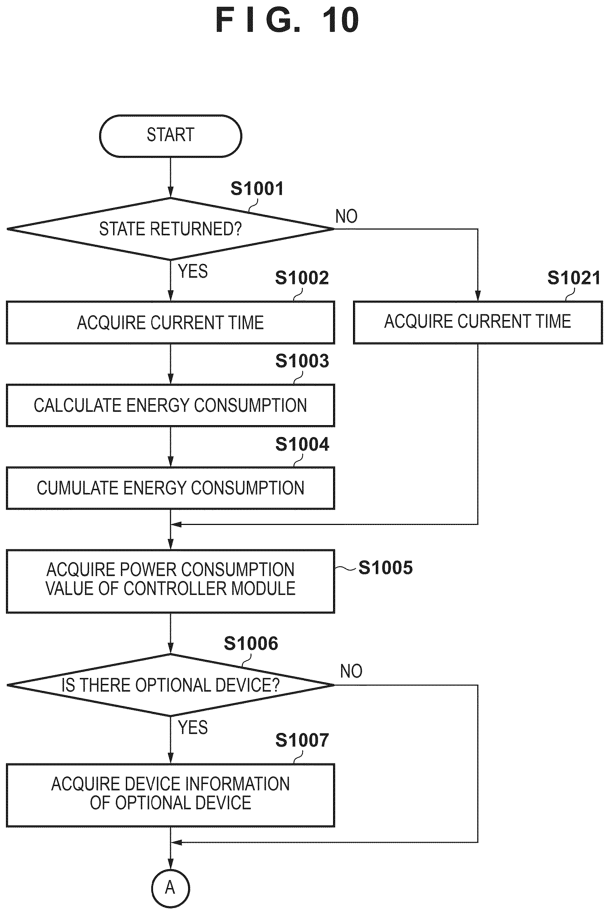

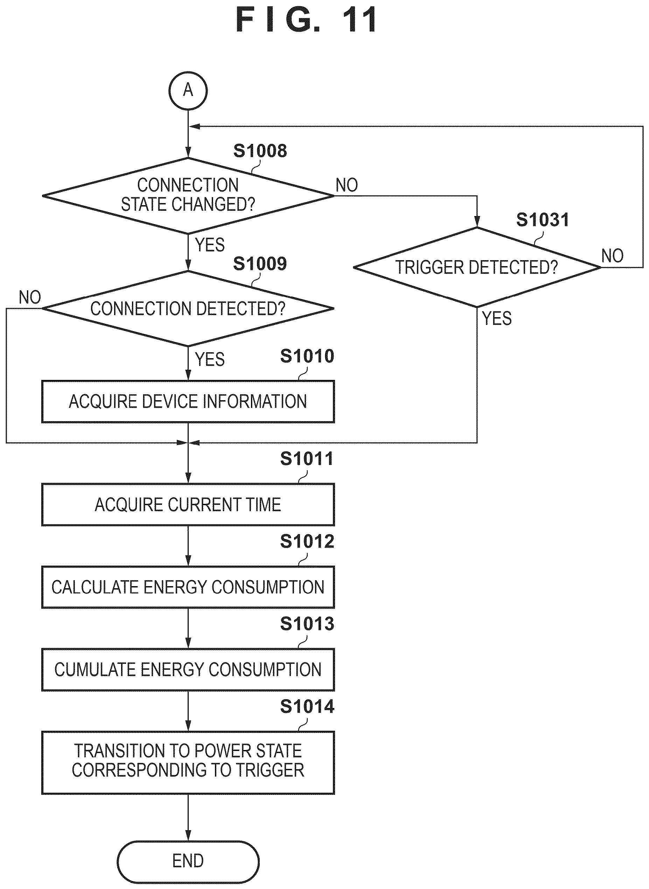

FIGS. 10 and 11 show a control method executed by the computation unit 101 in accordance with a control program. Here, when the power state of the image forming apparatus 10 changes, the following processing is executed.

In step S1001, the computation unit 101 determines whether or not the power state of the image forming apparatus 10 has returned from the second power saving state to the first power saving state or the standby state. If the second power saving state continues, the computation unit 101 moves from step S1001 to step S1021 and acquires the current time from the timer 118. Thereafter, the computation unit 101 moves from step S1021 to step S1005. If the power state has returned from the second power saving state to another state, the computation unit 101 moves from step S1001 to step S1002.

In step S1002, the computation unit 101 acquires the current time from the timer 118. In step S1003, the computation unit 101 calculates the amount of energy consumed between the previously acquired time and the current time. These times are the times when state transitions occurred. In other words, a specific power state is maintained during the period from the previously acquired time to the current time.

In step S1004, the computation unit 101 cumulates the calculated energy consumption. The result is added to the cumulative energy consumption. In the second power saving state, the computation unit 101 does not receive power and therefore cannot execute energy consumption calculation. Therefore, after the power state has returned from the second power saving state to another state, the energy consumption during the period in which the device was in the second power saving state is calculated. Time information indicating the current time may be stored in either the volatile memory 103 or the non-volatile memory 104. In the first embodiment, the time information is stored in the volatile memory 103.

In step S1005, the computation unit 101 acquires, from the non-volatile memory 104, the power consumption value of the controller module 100 that matches the current power state of the image forming apparatus 10. For example, the computation unit 101 refers to the first table 641 in the non-volatile memory 104 and acquires the power consumption value that corresponds to the current power state. For example, the power consumption value that corresponds to the combination of the power state and the operation state is acquired.

In step S1006, the computation unit 101 determines, through the option control unit 600, whether or not optional devices 500 are connected to the image forming apparatus 10. If optional devices 500 are connected, the computation unit 101 moves from step S1006 to step S1007. In step S1007, the computation unit 101 acquires the energy consumption of the optional devices 500. For example, the computation unit 101 refers to the second table 642 in the non-volatile memory 104 and acquires the power consumption values that correspond to the current power state. The power consumption values are cumulated along the time axis to obtain the energy consumption. If no optional devices 500 are connected, the computation unit 101 moves from step S1006 to step S1008.

In step S1008, the computation unit 101 determines through the option control unit 600 whether or not the connection state of an optional device 500 has changed. Examples of change in the connection state include the case where an optional device 500 is connected to the image forming apparatus 10 and the case where an optional device 500 is removed from the image forming apparatus 10. If the connection state of an optional device 500 has not changed, the computation unit 101 moves from step S1008 to step S1031. In step S1031, the computation unit 101 determines whether or not a trigger has been detected. Here, the trigger may be any trigger that brings about a change in the power state. If a trigger has not been detected, the computation unit 101 moves from step S1031 to step S1008. If a trigger is detected, the computation unit 101 moves from step S1031 to step S1011.

If a change in the connection state is detected in step S1008, the computation unit 101 moves from step S1008 to step S1009. In step S1009, the computation unit 101 determines through the option control unit 600 whether or not connection of an optional device 500 has been detected. If removal of an optional device 500 is detected, the computation unit 101 moves from step S1009 to step S1011. If connection of an optional device 500 is detected, the computation unit 101 moves from step S1009 to step S1010.

In step S1010, the computation unit 101 acquires device information of the optional device 500 via the option control unit 600. The option control unit 600 may perform communication with the optional device 500 to acquire the device ID, device category information, and the like.

In step S1011, the computation unit 101 acquires the current time from the timer 118. This time is the time when the connection state of the optional device 500 changed or when a trigger was detected.

In step S1012, the computation unit 101 acquires, from the memory 104, the power consumption value that corresponds to the current power state, and calculates the energy consumption during the period from the previous time to the current time. The computation unit 101 refers to the first table 641 and the second table 642 using the current power state, and acquires the power consumption value that corresponds to the current power state. For example, the computation unit 101 enumerates the optional devices 500 that are connected to the image forming apparatus 10, and acquires the power consumption value of each of the enumerated optional devices 500. As a result, it is possible to obtain energy consumption that takes into account the power state of the image forming apparatus 10 and the energization states of the optional devices 500. In other words, even when optional devices 500 are connected to the image forming apparatus 10, the energization states of the optional devices 500 change according to the power state. In other words, the power consumption values of the optional devices 500 change according to the power state. Since the power consumption values of the optional devices 500 that correspond to the power state are taken into account, the energy consumption of the image forming apparatus 10 can be calculated more accurately.

In step S1013, the computation unit 101 adds the energy consumption during the period from the previous time to the current time to the cumulative energy consumption. Since it is necessary to calculate the cumulative energy consumption, the energy consumption in the specific period of time is added to the cumulative energy consumption up to that point. The cumulative energy consumption is stored in the non-volatile memory 104. The cumulative energy consumption may be stored in the volatile memory 103. In this case, the cumulative energy consumption may be written from the memory 103 to the memory 104 when the power state transitions to the second power saving state and when the power state transitions to power OFF. In other words, the writing of the cumulative energy consumption to the memory 104 may be performed as part of suspend processing or shutdown processing.

In step S1014, the computation unit 101 transitions to the power state that corresponds to the trigger.

According to the first embodiment, the energy consumption WA of the image forming apparatus 10 is calculated based on the energy consumption of the controller module 100 and the energy consumption of the optional devices 500. As a result, the energy consumption WA of the entire image forming apparatus 10 can be calculated with high accuracy. In particular, even when an optional device 500 is connected to the image forming apparatus 10, if power is not supplied to that optional device 500, the energy consumption of that optional device 500 is not added to the energy consumption WA. In other words, the computation unit 101 adds the power consumption values of the internal loads (e.g., the controller module 100 and the like) and the power consumption values of the external loads (e.g., the optional devices 500) in accordance with the power supply states of the external loads. Furthermore, even if the connection state of an optional device 500 changes dynamically, the energy consumption is calculated with high accuracy.

The memory 104 and the second table 642 function as a storage unit that stores the power consumption value of the external load for each of a plurality of power supply states (e.g., on/off). The monitoring unit 601 monitors the power supply state of the external load connected to the connection unit (e.g., the I/F 109 or 110). The computation unit 101 may acquire, from the storage unit, the power consumption value of the external load that corresponds to the power supply state of the external load acquired by the monitoring unit 601.

As shown in FIGS. 3, 4, 7 and 8, the image forming apparatus 10 may have a plurality of power states. The monitoring unit 601 may acquire the power supply state of the external load from the second table 642 in accordance with the power state applied in the image forming apparatus 10 among the plurality of power states.

The computation unit 101 may calculate the energy consumption by cumulating, along the time axis, the total value of the power consumption value of the internal load and the power consumption value of the external load. This is the same as calculating the energy consumption of the internal load and the energy consumption of the external load separately before performing cumulating.

As suggested by FIGS. 10 and 11, the computation unit 101 may cumulate the energy consumption for each period during which a specific power state continues. This makes it easier to cumulate the energy consumption.

As suggested in FIG. 2, the computation unit 101 may cumulate the energy consumption for each predetermined statistical period. The user may wish to know the energy consumption for each predetermined statistical period. For this reason, the cumulation period and the statistical period may be different.

As suggested in FIG. 5, the computation unit 101 may acquire individual power consumption values for a plurality of function modules and add up the acquired individual power consumption values to obtain the power consumption values of the internal loads. Note that individual energy consumptions may be obtained for a plurality of function modules, and the acquired individual energy consumptions may be added up. This makes it possible to enable applying an appropriate calculation method for each function module when calculating the energy consumption.

As shown in FIG. 1, the power supply 190 is a power supply device that supplies power to the internal loads and the external loads. The computation unit 101 and the power supply circuit 191 may function as a supply control unit that controls the supply of power to the external loads via the connection units. Accordingly, the supply of power to an external load can be controlled separately for each external load. As a result, it is possible to improve the overall effect of power saving for the image forming apparatus 10.

The power supply circuit 191 functioning as the supply control unit and the computation unit 101 functioning as the computation unit may be implemented on the board 100a. In other words, the board on which the power supply circuit 191 is implemented and the board on which the computation unit 101 is implemented may be the same board. This makes it possible to reduce the number of boards provided in the image forming apparatus 10.

As suggested by the second table 642, the power supply circuit 191 may switch the state of power supply to external loads in accordance with state transitions that occur between power states. This is because the power state and the energization states of the optional devices 500 are associated with each other.

As shown in FIG. 8, the memory 104 and the second table 642 function as a storage unit that stores the power consumption value of the external load for each of a plurality of power states. The computation unit 101 may acquire the power consumption value that is associated with the current power state from the second table 642. In other words, the computation unit 101 may acquire the power consumption value from the second table 642 without identifying the power supply state of the external load. This is because the power state is associated with the power supply state, and therefore the power state itself may be recognized as the power supply state.

As shown in FIGS. 7 and 8, the power states may include JOB, STANDBY, SLEEP I, and SLEEP II. JOB is a power state in which the image forming apparatus 10 executes a job. STANDBY is a power state in which the image forming apparatus 10 waits for input of a job. SLEEP I and II are power states in which the image forming apparatus is in a sleep state. The power consumption value in SLEEP II is lower than the power consumption value in SLEEP I. The power consumption value in SLEEP I is lower than the power consumption value in STANDBY. The power consumption value in STANDBY is lower than the power consumption value in JOB.

As shown in FIG. 8, the power consumption value of the external load in SLEEP II is lower than the power consumption value of the external load in SLEEP I.

As shown in FIG. 7, JOB may include a first sub state in which image formation is executed, a second sub state in which reading of an original is executed, and a third sub state in which both reading of an original and image formation of the image read from the original are executed. The power consumption value in the first sub state, the power consumption value in the second sub state, and the power consumption value in the third sub state may be different from each other. Alternatively, as illustrated in FIG. 7, the power consumption value in the first sub state and the power consumption value in the second sub state may be equivalent to each other. In this way, the power consumption value in the first sub state and the power consumption value in the third sub state may be different. The power consumption value in the second sub state and the power consumption value of the third sub state may be different.

The I/Fs 109 and 110 may have connectors that comply with a predetermined technical standard. The optional devices 500 are examples of peripheral equipment that comply with a predetermined technical standard. The technical standard may be, for example, the Universal Serial Bus standard.

As shown in FIG. 8, the second table 642 may store power consumption values of external loads that comply with a first version of a technical standard (e.g., USB 2.0) and power consumption values of external loads that comply with a second version of the technical standard (e.g., USB 3.0). When an external load is connected to a first connector, the computation unit 101 may acquire, from the second table 642, the power consumption value of the external load that complies with the first version of the technical standard. When an external load is connected to the second connector, the computation unit 101 may acquire, from the second table 642, the power consumption value of the external load that complies with the second version of the technical standard. In this way, the power consumption values may differ according to the standard of the connector and the interface. Therefore, by calculating the power consumption value according to the version of the technical standard, it is possible to calculate the energy consumption with even higher accuracy.

The conversion unit 160 is an example of a communication conversion circuit used by the image forming apparatus to perform communication with a server computer. The computation unit 101 may acquire the power consumption value of the conversion unit 160 that is the external load. This is because, as shown in FIG. 8, when the power consumption value of the conversion unit 160 is large, the power consumption value of the conversion unit 160 also contributes to the overall energy consumption of the image forming apparatus 10.

As shown in FIG. 2, when displaying the cumulative value of the total values of the power consumption values of the internal loads and the power consumption values of the external loads, the display device of the operation unit 120 may display a cumulative value for each predetermined statistical period. This enables the user to more easily understand the overall power consumption of the image forming apparatus 10.

The tab 201 functions as a switching unit for switching the position of the predetermined statistical period along the time axis or the length of the predetermined statistical period. This enables the user to easily switch between statistical periods.

Variations

In the first embodiment, the first table 641 and the second table 642 are stored in the memory 104, but this is merely an example. The first table 641 and the second table 642 may be stored in a server computer connected to a wired LAN or a wireless LAN. The computation unit 101 may access the server computer via the I/F 108 or the I/F 111 and refer to the first table 641 and the second table 642 or download the first table 641 and the second table 642 to the memory 104, for example.

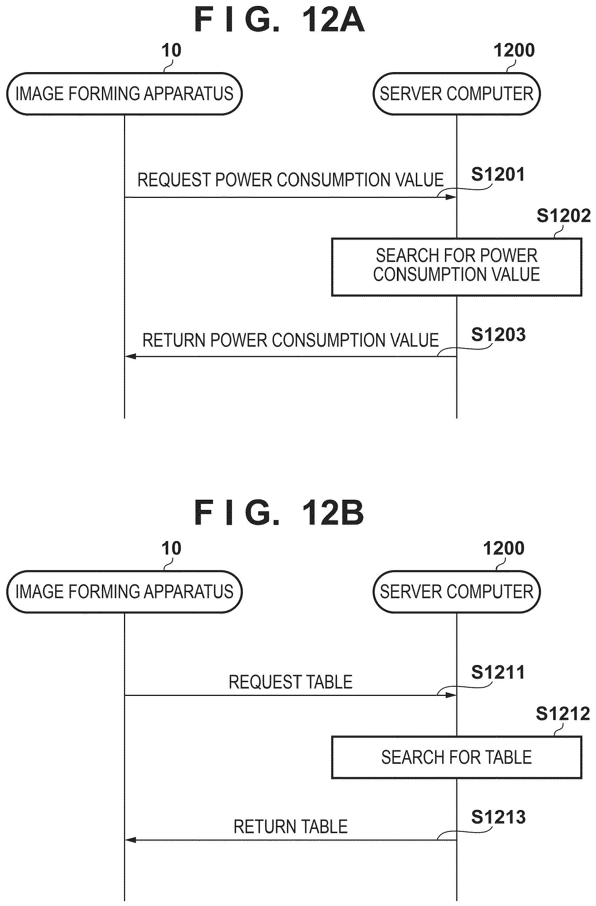

As shown in FIG. 12A, the computation unit 101 may acquire the power consumption value of an external load from outside the image forming apparatus 10. As described above, a server computer 1200 in an external network may store the first table 641 and the second table 642. The server computer 1200 includes a CPU, a communication circuit, and a storage device (a RAM, a ROM, a hard disk drive, or a solid-state drive). The storage device of the server computer 1200 stores the first table 641 and the second table 642.

In step S1201, the computation unit 101 accesses the server computer 1200 via the control unit 107 and the I/F 108, and transmits a request for a power consumption value. Here, a request related to the first table 641 includes information indicating the power state and information indicating the operation state. A request related to the second table 642 includes identification information of the optional device as well as the power state or the energization state.

In step S1202, the server computer 1200 receives the request, and searches the first table 641 or the second table 642 to extract the power consumption value that corresponds to the request.

In step S1203, the server computer 1200 transmits the power consumption value found in the search to the image forming apparatus 10. The computation unit 101 stores the power consumption value received from the server computer 1200 in the memory 104 or the memory 103, and uses the value when calculating the energy consumption.

As shown in FIG. 12B, the computation unit 101 may acquire at least either the first table 641 or the second table 642 from a device outside the image forming apparatus 10.

In step S1211, the computation unit 101 accesses the server computer 1200 via the control unit 107 and the I/F 108, and transmits a request for the first table 641 or the second table 642. Here, the request related to the first table 641 and the request related to the second table 642 may include identification information of the image forming apparatus 10. This is because the table may differ according to the model of the image forming apparatus 10.

In step S1212, the server computer 1200 receives the request, and searches for and extracts the first table 641 or the second table 642 that corresponds to the request.

In step S1213, the server computer 1200 transmits the first table 641 or the second table 642 found in the search to the image forming apparatus 10. The computation unit 101 stores the first table 641 or the second table 642 received from the server computer 1200 in the memory 104 or the memory 103, and uses the received table when calculating the energy consumption.

Other Embodiments

Embodiment(s) of the present disclosure can also be realized by a computer of a system or apparatus that reads out and executes computer executable instructions (e.g., one or more programs) recorded on a storage medium (which may also be referred to more fully as a 'non-transitory computer-readable storage medium') to perform the functions of one or more of the above-described embodiment(s) and/or that includes one or more circuits (e.g., application specific integrated circuit (ASIC)) for performing the functions of one or more of the above-described embodiment(s), and by a method performed by the computer of the system or apparatus by, for example, reading out and executing the computer executable instructions from the storage medium to perform the functions of one or more of the above-described embodiment(s) and/or controlling the one or more circuits to perform the functions of one or more of the above-described embodiment(s). The computer may comprise one or more processors (e.g., central processing unit (CPU), micro processing unit (MPU)) and may include a network of separate computers or separate processors to read out and execute the computer executable instructions. The computer executable instructions may be provided to the computer, for example, from a network or the storage medium. The storage medium may include, for example, one or more of a hard disk, a random-access memory (RAM), a read only memory (ROM), a storage of distributed computing systems, an optical disk (such as a compact disc (CD), digital versatile disc (DVD), or Blu-ray Disc (BD)™), a flash memory device, a memory card, and the like.

Various embodiments have been described in detail above but it will be understood that the present disclosure is not limited to these embodiments and encompasses all modifications, variants, alternatives and equivalents falling within the scope of the appended claims.

**Claims**

1.   An image forming apparatus (10) comprising:

an internal load (100; 130; 140; 150) provided inside the image forming apparatus;
connection means (109; 110) to which an external load is connectable; and
computation means (101) for calculating a power consumption value of the internal load, wherein the computation means adds a power consumption value of the external load connected to the connection means and the power consumption value of the internal load in accordance with a power supply state of the external load.

2.   The image forming apparatus according to Claim 1, further comprising:

storage means (104) for storing a plurality of the power consumption values respectively corresponding to a plurality of the power supply states of the external load connected to the connection unit; and
monitoring means (601) for monitoring the power supply state of the external load connected to the connection means,
wherein the computation means acquires the power consumption value of the external load stored in the storage means in accordance with the power supply state of the external load acquired by the monitoring means, and adds the acquired power consumption value of the external load to the power consumption value of the internal load.

3.   The image forming apparatus according to Claim 2,

wherein the image forming apparatus is further adapted to operate in a plurality of power states, and
the monitoring means acquires the power supply state of the external load in accordance with the power state selected from the plurality of power states in which the image forming apparatus operates.

4.   The image forming apparatus according to Claim 1, wherein the computation means obtains an energy consumption by cumulating, along a time axis, a total value of the power consumption value of the internal load and the power consumption value of the external load.

5.   The image forming apparatus according to Claim 4,

wherein the image forming apparatus has a plurality of power states, and
the computation means cumulates the energy consumption for each of a plurality of periods in which a specific power state among the plurality of power states continues, and cumulates the energy consumption for each of a plurality of predetermined statistical periods.

6.   The image forming apparatus according to Claim 1, wherein the computation means acquires an individual power consumption value for each of a plurality of function modules included as internal loads in the image forming apparatus, and obtains a power consumption value of the internal loads by adding up the acquired individual power consumption values.

7.   The image forming apparatus according to Claim 6, wherein the plurality of function modules include

a scanner module that reads an original,
a controller module controls the image forming apparatus,
a printer module forms a toner image on a recording medium, and

a fixing module fixes the toner image to the recording medium.

8. The image forming apparatus according to Claim 1, further comprising:

power supply means (190) for supplying power to the internal load and the external load connected to the connection means; and
supply control means (191) for controlling supply of power to the external load via the connection means.

9. The image forming apparatus according to Claim 8, further comprising a board on which the supply control means and the computation means are implemented.

10. The image forming apparatus according to Claim 8,

wherein the image forming apparatus has a plurality of power states, and
the supply control means switches the power supply state of the external load in accordance with a state transition between the plurality of power states.

11. The image forming apparatus according to Claim 10, further comprising storage means (104) for storing the power consumption value of the external load for each of the plurality of power states of the image forming apparatus,
wherein the computation means acquires, from the storage means, the power consumption value of the external load that corresponds to a current power state of the image forming apparatus.

12. The image forming apparatus according to Claim 11,

wherein the plurality of power states include a first state, a second state, and a third state,
the first state is a power state in which the image forming apparatus executes a job,
the second state is a power state in which the image forming apparatus waits for input of a job,
the third state is a power state in which the image forming apparatus is in a sleep state,
the power consumption value of the image forming apparatus in the third state is lower than the power consumption value of the image forming apparatus in the second state, and
the power consumption value of the image forming apparatus in the second state is lower than the power consumption value of the image forming apparatus in the first state.

13. The image forming apparatus according to Claim 12,

wherein the plurality of power states further include a fourth state,
the fourth state is a power state in which the image forming apparatus is in a sleep state, and
the power consumption value of the image forming apparatus in the fourth state is lower than the power consumption value of the image forming apparatus in the third state.

14. The image forming apparatus according to Claim 13, wherein the power consumption value of the external load in the fourth state is lower than the power consumption value of the external load in the third state.

15. The image forming apparatus according to Claim 12,

wherein the first state includes,

a first sub state in which image formation is executed,
a second sub state in which original reading is executed, and
a third sub state in which both original reading and image formation of an image read from the original are executed, and

a power consumption value in the first sub state and a power consumption value in the third sub state are different from each other, and a power consumption value in the second sub state and the power consumption value in the third sub state are different from each other.

16. The image forming apparatus according to Claim 1,

wherein the connection means includes a connector complying with a predetermined technical standard, and
the external load includes peripheral equipment complying with the predetermined technical standard.

17. The image forming apparatus according to Claim 1, further comprising storage means for storing (104) a power consumption value of an external load complying with a first version of a technical standard and a power consumption value of an external load complying with a second version of the technical standard,

wherein the connection means includes

a first connector complying with the first version of the technical standard, and
a second connector complying with the second version of the technical standard,

in a case where an external load is connected to the first connector, the computation means acquires, from the storage means, the power consumption value of the external load complying with the first version of the technical standard, and

in a case where an external load is connected to the second connector, the computation means acquires, from the storage means, the power consumption value of the external load complying with the second version of the technical standard.

18. The image forming apparatus according to Claim 17, wherein the technical standard is Universal Serial Bus standard.

19. The image forming apparatus according to Claim 1,

wherein the connection means is connected to a communication conversion circuit used by the image forming apparatus to perform communication with a server computer, and the computation means acquires a power consumption value of the communication conversion circuit that is the external load.

20. The image forming apparatus according to Claim 1, further comprising display means (120) for displaying, for each of a plurality of predetermined statistical periods, a cumulative value regarding a total value of the power consumption value of the internal load and the power consumption value of the external load.

21. The image forming apparatus according to Claim 20, further comprising switching means (201) for switching a position of the predetermined statistical period along a time axis and switching a length of the predetermined statistical period.

22. The image forming apparatus according to Claim 1, wherein the computation means acquires the power consumption value of the external load from outside the image forming apparatus.

# FIG. 1

**10**

**120** OPERATION UNIT

**150** FIXING MODULE

**119** I/F

**100a** **100**

**115** USB 2.0 DEVICE

**109** I/F

**116** USB 3.0 DEVICE

**110** I/F

**117** WLAN DEVICE

**111** I/F

**118** TIMER

**101** COMPUTATION UNIT

**102** IMAGE PROCESSING UNIT

**112** I/F

**160** CONVERSION UNIT

**113** I/F

**130** SCANNER MODULE

**131** CONTROL UNIT

**132** DRIVE UNIT

**108** I/F

**107** CONTROL UNIT

**114** I/F

**140** PRINTER MODULE

**190** POWER SUPPLY

**191** POWER SUPPLY CIRCUIT

**104** MEMORY

**103** MEMORY

**105** MEMORY

**106** MEMORY

**141** CONTROL UNIT

**142** DRIVE UNIT

EP 4 733 849 A1

EP 4 733 849 A1

# F I G. 2

**201** **210** **204** **210** **200**

day ▼ [2024/08/04 ~ 2024/08/10]

ENERGY
CONSUMPTION
(kWh)

20
15
10
5
0

08/04 08/05 08/06 08/07 08/08 08/09 08/10

# F I G. 3

JOB

STAND-BY

SLEEP

SLEEP I   SLEEP II

# F I G. 4

POWER CONSUMPTION VALUE [W]

FIXING DEVICE

W-UP

RD

SLEEP

PRINT (FIXING)

PRINT

STANDBY

TIME [s]

SLEEP STATE

PRINT STATE

STANDBY STATE

SLEEP STATE

# F I G. 5

```
┌─────────────────────────────────────────────────────────┐
│  ┌─────────────────────────────────┐                     │
│  │ SCANNER MODULE                  ┆ ---- 130            │
│  │                                 ┆ ----→ Wm1           │
│  └─────────────────────────────────┘                     │
│  ┌─────────────────────────────────┐                     │
│  │ CONTROLLER MODULE               ┆ ---- 100            │
│  │                                 ┆ ----→ Wm2           │
│  └─────────────────────────────────┘                     │
│  ┌─────────────────────────────────┐ ---- 500            │
│  │ OPTIONAL DEVICE                 ┆                     │
│  │  ┌──────────────────────────┐   ┆                     │
│  │  │   USB 2.0 DEVICE         │── 115                   │
│  │  ┌──────────────────────────┐   ┆                     │
│  │  │   USB 3.0 DEVICE         │── 116  ----→ Wm3         │
│  │  ┌──────────────────────────┐   ┆                     │
│  │  │   WLAN DEVICE            │── 117           → WA     │
│  │  ┌──────────────────────────┐   ┆                     │
│  │  │   CONVERSION UNIT        │── 160                    │
│  └─────────────────────────────────┘                     │
│  ┌─────────────────────────────────┐                     │
│  │ FIXING MODULE                   ┆ ---- 150            │
│  │                                 ┆ ----→ Wm4           │
│  └─────────────────────────────────┘                     │
│  ┌─────────────────────────────────┐ ---- 140            │
│  │ PRINTER MODULE                  ┆                     │
│  │  ┌──────────────────────────┐   ┆                     │
│  │  │   MOTOR                  │── 501                    │
│  │  ┌──────────────────────────┐   ┆                     │
│  │  │ CHARGING POWER SUPPLY    │── 502                    │
│  │  ┌──────────────────────────┐   ┆                     │
│  │  │ EXPOSURE DEVICE          │── 503  ----→ Wm5         │
│  │  ┌──────────────────────────┐   ┆                     │
│  │  │ DEVELOPMENT POWER SUPPLY │── 504                    │
│  │  ┌──────────────────────────┐   ┆                     │
│  │  │ PRIMARY TRANSFER         │── 505                    │
│  │  │ POWER SUPPLY             │                          │
│  │  ┌──────────────────────────┐   ┆                     │
│  │  │ SECONDARY TRANSFER       │── 506                    │
│  │  │ POWER SUPPLY             │                          │
│  └─────────────────────────────────┘                     │
└─────────────────────────────────────────────────────────┘
```

# FIG. 6

COMPUTATION UNIT **101**

**600** OPTION CONTROL UNIT

**601** MONITORING UNIT

**610** INDIVIDUAL ACQUISITION UNIT

**611** $W_{m1}$ ACQUISITION UNIT

**612** $W_{m2}$ ACQUISITION UNIT

**613** $W_{m3}$ ACQUISITION UNIT

**614** $W_{m4}$ ACQUISITION UNIT

**615** $W_{m5}$ ACQUISITION UNIT

**620** CUMULATION UNIT

**630** DISPLAY CONTROL UNIT

**118** TIMER

**120** OPERATION UNIT

**670** COMMUNICATION CIRCUIT

**500** OPTIONAL DEVICE

**680** BATTERY

**104** MEMORY

TABLE **641**

TABLE **642**

**103** MEMORY

EP 4 733 849 A1

# F I G. 7

641

| Key# | POWER STATE | OPERATION STATE | POWER CONSUMPTION VALUE [W] |
|---|---|---|---|
| 0x1 | JOB | PRINT + SCAN | 35 |
| 0x2 | | PRINT | 30 |
| | | SCAN | |
| 0x3 | STANDBY | JOB ACCEPT | 20 |
| 0x4 | SLEEP | FIRST POWER SAVING STATE | 8 |
| 0x5 | | SECOND POWER SAVING STATE | 0.5 |
| 0x6 | OFF | POWER OFF | 0 |

# F I G. 8

EP 4 733 849 A1

642

| Key# | OPTIONAL DEVICE | I/F | POWER STATE | ENERGIZATION STATE | POWER CONSUMPTION VALUE [W] |
|---|---|---|---|---|---|
| 0x11 | USB 2.0 DEVICE | USB 2.0 I/F | JOB | ON | 2.5 |
| | | | STANDBY | | |
| | | | SLEEP I | | |
| 0x12 | | | SLEEP II | OFF | 0 |
| 0x13 | USB 3.0 DEVICE | USB 3.0 I/F | JOB | ON | 4.5 |
| | | | STANDBY | | |
| | | | SLEEP I | | |
| 0x14 | | | SLEEP II | OFF | 0 |
| 0x15 | WLAN DEVICE | WLAN I/F | JOB | ON | 2.5 |
| | | | STANDBY | | |
| | | | SLEEP I | | |
| 0x16 | | | SLEEP II | | 0.25 |
| 0x17 | CONVERSION UNIT | PRINTER SERVER I/F | JOB | ON | 30 |
| 0x18 | | | STANDBY | | 10 |
| 0x19 | | | SLEEP I | OFF | 0 |
| | | | SLEEP II | | |

# FIG. 9

POWER CONSUMPTION OF CONTROLLER

POWER CONSUMPTION OF CONVERSION UNIT

POWER CONSUMPTION OF USB 3.0 DEVICE

POWER CONSUMPTION VALUE [W]

USB MEMORY CONNECTED

Job STARTED

Job COMPLETED

SPECIFIED TIME ELAPSED

SPECIFIED TIME ELAPSED

RETURN TRIGGER

USB MEMORY REMOVED

TIME [s]

| STANDBY | JOB | STANDBY | SLEEP I | SLEEP II | STANDBY |

t0    t1    t2    t3    t4    t5    t6    t7    t8

EP 4 733 849 A1

# F I G. 10

```
              ( START )
                  │
                  ▼            S1001
         ◇ STATE RETURNED? ◇──────NO──────┐
                  │                        │
                 YES        S1002          │        S1021
                  ▼                        ▼
         ┌──────────────────┐   ┌──────────────────┐
         │ ACQUIRE CURRENT  │   │ ACQUIRE CURRENT  │
         │      TIME        │   │      TIME        │
         └──────────────────┘   └──────────────────┘
                  │   S1003              │
                  ▼                      │
         ┌──────────────────┐           │
         │ CALCULATE ENERGY │           │
         │   CONSUMPTION    │           │
         └──────────────────┘           │
                  │   S1004              │
                  ▼                      │
         ┌──────────────────┐           │
         │ CUMULATE ENERGY  │           │
         │   CONSUMPTION    │           │
         └──────────────────┘           │
                  │                      │
                  ◀──────────────────────┘
                  ▼
         ┌──────────────────────┐
         │ ACQUIRE POWER        │── S1005
         │ CONSUMPTION VALUE    │
         │ OF CONTROLLER MODULE │
         └──────────────────────┘
                  │   S1006
                  ▼
         ◇ IS THERE OPTIONAL DEVICE? ◇──NO──┐
                  │                          │
                 YES        S1007            │
                  ▼                          │
         ┌──────────────────────┐           │
         │ ACQUIRE DEVICE       │           │
         │ INFORMATION OF       │           │
         │ OPTIONAL DEVICE      │           │
         └──────────────────────┘           │
                  │                          │
                  ◀──────────────────────────┘
                  ▼
                 ( A )
```

# F I G. 11

(A)

**S1008**
CONNECTION STATE CHANGED? — NO

YES

**S1009**
NO — CONNECTION DETECTED?

YES **S1010**

ACQUIRE DEVICE INFORMATION

**S1031**
TRIGGER DETECTED? — NO

YES

**S1011**

ACQUIRE CURRENT TIME

**S1012**

CALCULATE ENERGY CONSUMPTION

**S1013**

CUMULATE ENERGY CONSUMPTION

**S1014**

TRANSITION TO POWER STATE CORRESPONDING TO TRIGGER

END

# F I G. 12A

**10**

**1200**

IMAGE FORMING APPARATUS

SERVER COMPUTER

REQUEST POWER CONSUMPTION VALUE — **S1201**

**S1202**

SEARCH FOR POWER CONSUMPTION VALUE

RETURN POWER CONSUMPTION VALUE — **S1203**

# F I G. 12B

**10**

**1200**

IMAGE FORMING APPARATUS

SERVER COMPUTER

REQUEST TABLE — **S1211**

**S1212**

SEARCH FOR TABLE

RETURN TABLE — **S1213**

Europäisches
Patentamt
European
Patent Office
Office européen
des brevets

# EUROPEAN SEARCH REPORT

**Application Number**

EP 25 20 8199

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2015/264208 A1 (ACHIWA KEN [JP] ET AL) 17 September 2015 (2015-09-17) | 1-3, 5-19,22 | INV. G03G15/00 |
| Y | * paragraphs [0059] - [0067], [0135] - [0164]; figures * | 4,20,21 | G06F1/3234 H04N1/00 |
| Y | US 2020/250501 A1 (YAMAMOTO TAKAYUKI [JP]) 6 August 2020 (2020-08-06) * paragraphs [0063] - [0065]; figure 8 * | 4,20,21 | |
| A | JP 2015 174374 A (CANON KK) 5 October 2015 (2015-10-05) * abstract * | 1-22 | |

**TECHNICAL FIELDS SEARCHED (IPC)**

G03G
H04N
G06F

The present search report has been drawn up for all claims

| Place of search | Date of completion of the search | Examiner |
|---|---|---|
| Munich | 20 February 2026 | Urbaniec, Tomasz |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 25 20 8199

This annex lists the patent family members relating to the patent documents cited in the above-mentioned European search report.
The members are as contained in the European Patent Office EDP file on
The European Patent Office is in no way liable for these particulars which are merely given for the purpose of information.

20-02-2026

| Patent document cited in search report | Publication date | Patent family member(s) | | Publication date |
|---|---|---|---|---|
| US 2015264208 A1 | 17-09-2015 | JP | 6448200 B2 | 09-01-2019 |
| | | JP | 2015176442 A | 05-10-2015 |
| | | US | 2015264208 A1 | 17-09-2015 |
| US 2020250501 A1 | 06-08-2020 | JP | 7192537 B2 | 20-12-2022 |
| | | JP | 2020121502 A | 13-08-2020 |
| | | US | 2020250501 A1 | 06-08-2020 |
| JP 2015174374 A | 05-10-2015 | JP | 6815714 B2 | 20-01-2021 |
| | | JP | 2015174374 A | 05-10-2015 |

EPO FORM P0459

For more details about this annex : see Official Journal of the European Patent Office, No. 12/82

**EP 4 733 849 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2016064521 A